(19) Europäisches Patentamt
European Patent Office
Office européen des brevets

(11) Veröffentlichungsnummer : **0 101 587**
**B1**

(12) **EUROPÄISCHE PATENTSCHRIFT**

(45) Veröffentlichungstag der Patentschrift : **21.01.87**

(51) Int. Cl.[4] : **G 03 F 7/10**

(21) Anmeldenummer : **83107690.6**

(22) Anmeldetag : **04.08.83**

(54) **Positiv arbeitendes Verfahren zur Herstellung von Reliefbildern oder Resistmustern.**

(30) Priorität : **21.08.82 DE 3231147**

(43) Veröffentlichungstag der Anmeldung : **29.02.84 Patentblatt 84/09**

(45) Bekanntmachung des Hinweises auf die Patenterteilung : **21.01.87 Patentblatt 87/04**

(84) Benannte Vertragsstaaten : **BE CH DE FR GB IT LI NL**

(56) Entgegenhaltungen :
**EP-A- 0 019 770**
**DE-A- 2 150 691**
**DE-A- 2 242 394**
**DE-A- 2 309 062**

(73) Patentinhaber : **BASF Aktiengesellschaft**
**Carl-Bosch-Strasse 38**
**D-6700 Ludwigshafen (DE)**

(72) Erfinder : **Saenger, Dietrich, Dr.**
**Lorcher Ring 16 a**
**D-6710 Frankenthal (DE)**
Erfinder : **Leyrer, Reinhold J., Dr.**
**Menzelstrasse 4**
**D-6700 Ludwigshafen (DE)**

**EP 0 101 587 B1**

Anmerkung : Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

Jouve, 18, rue St-Denis, 75001 Paris, France

**Beschreibung**

Die Erfindung betrifft ein positiv arbeitendes Verfahren zur Herstellung von Reliefbildern oder Resistmustern auf einem Träger mittels eines lichtempfindlichen Aufzeichnungsmaterials mit einer auf dem Träger aufgebrachten festen lichtempfindlichen Resistschicht, die als lichtempfindliche Komponente eine aromatische und/oder heteroaromatische o-Nitrocarbinolestergruppierungen aufweisende Verbindung enthält. Zur Herstellung der Reliefbilder, wie z. B. Offsetdruckplatten, oder Resistmuster wird die lichtempfindliche Resistschicht bildmäßig mit aktinischem Licht belichtet und werden anschließend die belichteten Bereiche dieser Schicht mit einem wäßrigen Entwickler-Lösungsmittel ausgewaschen.

Es sind zahlreiche positiv arbeitende lichtempfindliche Aufzeichnungsmaterialien sowie Verfahren zur Bildherstellung mittels dieser Aufzeichnungsmaterialien bekannt. Unter positiv arbeitenden Aufzeichnungsmaterialien bzw. positiv arbeitenden Bildherstellungs-Verfahren werden dabei solche verstanden, bei denen nach der bildmäßigen Belichtung der lichtempfindlichen Schicht die belichteten Bereiche dieser Schicht in Lösungsmitteln löslich werden, in denen sie vorher unlöslich sind. Die belichteten Bereiche werden somit beim Entwickeln der lichtempfindlichen Schicht entfernt und man erhält ein positives Abbild der bildmäßigen Vorlage.

Positiv arbeitende Beschichtungsmaterialien auf Basis von o-Chinondiazidverbindungen, die bei Belichtung unter Bildung von alkalilöslichen Photolyseprodukten reagieren, wie sie z. B. in der DE-A-20 28 903 und der DE-A-22 36 941 beschrieben sind, haben nur eine geringe Lagerstabilität und zeigen bei erhöhter Lagertemperatur Zersetzungserscheinungen unter Stickstoffabspaltung. Ferner müssen diese Materialien auf metallischen Oberflächen schnell weiterverarbeitet werden, da die Zersetzung der Diazidgruppen durch Schwermetalle und Schwermetallsalze (z. B. in Galvanobädern) katalysiert wird. o-Chinondiazid-Derivate sind ferner gegen wäßrige Alkalien nicht beständig, was eine weitere Einschränkung ihrer Verwendung bedeutet.

Aus der DE-B2-22 58 880 ist es bekannt, durch bildmäßiges Belichten und anschließendes Entwickeln einer lichtempfindlichen Schicht positive Resistmuster herzustellen, indem man ein lichtempfindliches Gemisch verwendet, das ein Epoxidharz, ein tertiäres Amin, einen halogenierten Kohlenwasserstoff, Dicyanamid und ein Lösungsmittel enthält. Durch die bildmäßige Belichtung wird hierbei zunächst nur ein Unterschied in der Härtbarkeit der lichtempfindlichen Schicht hervorgerufen. Zur Erzeugung der für die Entwicklung des Resistmusters notwendigen Löslichkeitsdifferenzierung muß die lichtempfindliche Schicht nach der Belichtung durch Erwärmen gehärtet werden. Ein entscheidender Nachteil der aus der DE-B2-22 58 880 bekannten lichtempfindlichen Gemische ist deren geringe thermische Stabilität im unbelichteten Zustand, die die Handhabung und Verarbeitung dieser Gemische wesentlich beeinträchtigt. So lassen sich diese Systeme insbesondere nicht durch das heute übliche und bewährte trockene Schichtübertragungsverfahren verarbeiten.

In der DE-A-21 50 691 sowie der DE-A-29 22 746 werden positiv arbeitende Aufzeichnungsmaterialien für die Herstellung von Reliefbildern oder Resistmustern beschrieben, deren lichtempfindliche Schicht auf Basis von o-Nitrocarbinolestergruppierungen enthaltenden Polymeren aufgebaut ist, die nach der Belichtung mit einem alkalischen Lösungsmittel ausgewaschen werden können. Diese bekannten Beschichtungsmaterialien, die sich für die Herstellung von Resistschichten oder Flachdruckplatten eignen, sind zwar im unbelichteten Zustand gegenüber thermischer Beanspruchung unempfindlich, so daß sie eine hohe Lagerstabilität aufweisen und eine einfache Verarbeitbarkeit, beispielsweise durch Schichtübertragung, erlauben. Die Temperaturstabilität dieser Beschichtungsmaterialien nach dem Belichten und Entwickeln ist für viele Anwendungszwecke jedoch noch unzureichend, da die Festigkeit der hiermit hergestellten Resistschichten oberhalb 50 °C stark abnimmt. Weiterhin ist ihre Resistenz gegenüber starken und aggressiven Säuren und Laugen, wie sie beispielsweise in Galvanisier- oder Ätzbädern zur Anwendung gelangen können, zwar im allgemeinen hinreichend und zufriedenstellend, jedoch andererseits begrenzt und weiter verbesserungsbedürftig. Darüber hinaus ist auch die Kriechstromfestigkeit dieser Materialien noch nicht befriedigend, so daß sie für die Verwendung als Lötstoppmaske, beispielsweise bei der Herstellung von gedruckten Schaltungen, nur bedingt eingesetzt werden können.

Aus der DE-B-23 09 062 ist es ferner bereits bekannt, aus lichtempfindlichen Schichten, die eine aromatische o-Nitrocarbinolestergruppierungen aufweisende Verbindung und zusätzlich ein Epoxiharzpräpolymeres enthalten, Reliefbilder oder Resistmuster herzustellen, indem man die lichtempfindliche Schicht bildmäßig belichtet, durch eine Wärmebehandlung in der belichteten Schicht das durch die Belichtung hervorgerufene latente Bild selektiv härtet und anschließend die unbelichteten, ungehärteten Schichtanteile mit einem Lösungsmittel entfernt. Dieses Verfahren ist jedoch negativ arbeitend und bedarf organischer Lösungsmittel zur Entwicklung der belichteten und selektiv gehärte-ten Schicht. Um die Entwicklung in wäßrigen Lösungsmitteln vornehmen zu können, müssen in diesem Verfahren o-Nitrocarbinolestergruppierungen tragende Verbindungen eingesetzt werden, die als solche bereits wasserlöslich sind. in diesem Fall besitzt jedoch dann das Endprodukt, d. h. die hergestellten Reliefbilder oder Resistmuster, nicht die gewünschte und erforderliche Beständigkeit gegenüber den bei der Weiterverarbeitung verwendeten Prozeßchemikalien insbesondere starken Laugen oder Säuren, wie sie z. B. in Galvano- oder Ätzbädern zur Anwendung gelangen. Das gleiche gilt für die Festigkeit solcher

Schichten bei der Anwendung für Offsetdruckplatten, die hohe Auflagen nicht zulassen.

Schließlich sind in der DE-A-22 42 394 unter Lichteinwirkung härtbare Mischungen aus einer aromatische oder heteroaromatische o-Nitrocarbinolestergruppierungen tragenden Verbindung und Aziridin- oder Isocyanatgruppen enthaltenden Verbindungen beschrieben. Diese lichthärtbaren Gemische werden gemäß der Lehre der DE-A-22 42 394 zur Herstellung von Formkörpern, Imprägnierungen, Beschichtungen, Überzügen, Druckfarben etc. eingesetzt. Hierzu werden die aus diesen Gemischen hergestellten lichtempfindlichen Schichten und Überzüge vollflächig belichtet und durchgehärtet. Auch die Herstellung von Druckplatten für den Offsetdruck ist in dieser Druckschrift angesprochen.

Aufgabe der vorliegenden Erfindung ist es, ein positiv arbeitendes Verfahren zur Herstellung von Reliefbildern, wie insbesondere Offsetdruckplatten, oder Resistmustern mittels eines lichtempfindlichen Aufzeichnungsmaterials aufzuzeigen, welches bei hohem Auflösungsvermögen insbesondere in dünnen Schichten die Herstellung von Reliefbildern oder Resistmustern gestattet, die gute thermische Stabilität, hohe mechanische Festigkeit, verbesserte Resistenz gegenüber den in Galvano- oder Ätzbädern zur Anwendung gelangenden starken Laugen oder Säuren sowie darüber hinaus gute isolatorische Eigenschaften, wie Kriechstrom- und Durchschlagsfestigkeit, besitzen. Das Verfahren soll einfach durchführbar und umweltfreundlich sein, d. h. es soll mit wäßrigen Entwickler-Lösungsmitteln gearbeitet werden können ; ferner soll es variabel sein und dem jeweiligen Anwendungszweck leicht angepaßt werden können, so daß es eine große Anwendungsbreite besitzt.

Es wurde nun überraschenderweise gefunden, daß diese Aufgabe gelöst wird, wenn man von einem lichtempfindlichen Aufzeichnungsmaterial ausgeht, dessen lichtempfindliche Schicht eine Verbindung mit mindestens zwei aromatischen und/oder heteroaromatischen o-Nitrocarbinolestergruppierungen und eine vernetzend wirkende Verbindung mit mindestens zwei reaktiven Gruppen enthält, die mit —COOH-Gruppen unter Bildung einer kovalenten chemischen Bindung zu reagieren vermögen, wobei man diese lichtempfindliche Schicht bildmäßig mit aktinischem Licht belichtet, die belichteten Schichtanteile mit einem wäßrigen Entwickler-Lösungsmittel entfernt und das resultierende Reliefbild oder Resistmuster vollflächig mit aktinischem Licht bestrahlt und anschließend thermisch vernetzt und härtet.

Gegenstand der Erfindung ist demzufolge ein Verfahren zur Herstellung von Reliefbildern, insbesondere Flachdruckplatten, oder Resistmustern, die ein positives Abbild einer bildmäßigen Vorlage darstellen, bei dem eine auf einem Träger aufgebrachte feste lichtempfindliche Resistschicht die als lichtempfindliche Komponente eine Verbindung mit mindestens zwei aromatischen und/oder heteroaromatischen o-Nitrocarbinolestergruppierungen der Formel (I)

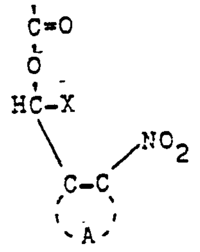

(I)

enthält, worin A den Rest eines aromatischen oder heteroaromatischen, gegebenenfalls substituierten Ringsystems mit 5 bis 14 Ringgliedern und X ein Wasserstoffatom, einen Alkylrest mit 1 bis 8 Kohlenstoffatomen oder einen gegebenenfalls substituierten Aryl- oder Aralkylrest bedeuten, bildmäßig mit aktinischem Licht belichtet wird und anschließend die belichteten Bereiche der Resistschicht mit einem wäßrigen Entwicklerlösungsmittel ausgewaschen werden, welches dadurch gekennzeichnet ist, daß die lichtempfindliche Resistschicht auch eine vernetzend wirkende Verbindung mit mindestens zwei reaktiven Gruppen enthält, die unter dem Einfluß von Wärme mit —COOH-Gruppen unter Bildung einer kovalenten chemischen Bindung zu reagieren vermögen, und daß die lichtempfindliche Resistschicht nach dem bildmäßigen Belichten und Entwickeln vollflächig mit aktinischem Licht nachbelichtet und anschließend thermisch vernetzt und gehärtet wird.

Obwohl die Entwicklung der bildmäßig belichteten Resistschicht mit wäßrigen Lösungsmitteln durchgeführt werden kann, führt das erfindungsgemäße Verfahren zu Reliefbildern und Resistmustern, die eine sehr hohe Beständigkeit gegenüber wäßrigen Behandlungsmitteln, insbesondere starken Laugen oder Säuren, wie sie in Galvano- oder Ätzbädern verwendet werden, aufweisen. Die erhaltenen Reliefbilder oder Resistmuster besitzen eine gute thermische Stabilität, d. h. sie haben auch bei höheren Temperaturen, z. B. über 100 °C noch sehr gute mechanische Festigkeiten. Sie haben darüber hinaus hohe Kriechstrom- und Durchschlagsfestigkeiten, die sie insbesondere zur Anwendung bei der Herstellung von gedruckten Schaltungen als Lötstoppmasken geeignet machen. Wegen des hohen Auflösungsvermögens der lichtempfindlichen Resistschicht können mit dem erfindungsgemäßen Verfahren auch sehr feine Bildelemente, wie Linien, Striche oder Punkte, vorlagengetreu und genau reproduziert werden, wobei sich das Verfahren insbesondere für die Reproduktion in dünnen Schichten eignet. Ein besonderer Vorteil des erfindungsgemäßen Verfahrens besteht darin, daß sich über die Zeit der vollflächigen Nachbelichtung, die Belichtungsintensität, die Art und Menge der in der lichtempfindlichen Schicht enthaltenen Verbindungen mit den gegenüber Carbonsäure-Resten reaktiven Gruppen sowie über die bei der Härtung angewandte Temperatur der Härtungsgrad und damit die Schichteigenschaften kontinuierlich je nach dem anschließenden Verwendungszweck einstellen lassen. Die hohe Abriebfestigkeit der nachgehärteten Bildelemente gestattet die Herstellung besonders auflagenstarker Flachdruckplatten.

Bei der Durchführung des erfindungsgemäßen Verfahrens wird ein lichtempfindliches Aufzeichnungsmaterial mit einer auf einem Träger aufgebrachten lichtempfindlichen Resistschicht eingesetzt. Die Wahl des Trägers richtet sich dabei nach dem Anwendungszweck der herzustellenden Reliefbilder oder Resistmuster. Als Träger kommen beispielsweise metallische, metalloxidische oder keramische Untergründe, aber auch Filme, Folien oder Platten aus polymeren Substanzen in Betracht. So werden beispielsweise für die Herstellung von Ätz- oder Galvanomustern als Träger Kupferbleche oder kupferkaschierte Substrate verwendet. Für die Herstellung von Dünnschichtschaltungen werden als Trägermaterial insbesondere Keramiksubstrate, die mit metallischen oder metalloxidischen Schichten beschichtet sind, oder Halbleiterelemente verarbeitet. Zur Herstellung von Reliefbildern, insbesondere Offset-Druckplatten, können als Träger Metalle, z. B. Stahl- oder Aluminium-Bleche, die mechanisch oder elektrochemisch aufgerauht sind bzw. eine anodisch erzeugte Oxidschicht besitzen, oder Kunststoffolien, z. B. aus Polyestern, die auch metallisch bedampft sein können, zur Anwendung gelangen. Für die Herstellung einer Lötstoppmaske kann die lichtempfindliche Resistschicht z. B. auf das Schaltbild einer gedruckten Schaltung als Träger aufgebracht werden. Die lichtempfindliche Resistschicht kann auf das Trägermaterial nach den bekannten Auftragstechniken entweder aus Lösung, z. B. durch spin-coating, Gießen, Tauchbeschichtung etc., oder trocken nach den üblichen Laminierverfahren aufgebracht werden.

In dem erfindungsgemäßen Verfahren werden solche lichtempfindlichen Resistschichten eingesetzt, die als lichtempfindliche Komponente eine Verbindung mit mindestens zwei aromatischen und/oder heteroaromatischen o-Nitrocarbinolestergruppierungen der allgemeinen Formel (I)

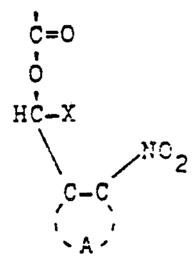

(I)

enthalten, worin A den Rest eines aromatischen oder heteroaromatischen, gegebenenfalls substituierten Ringsystems mit 5 bis 14 Ringgliedern und X ein Wasserstoffatom, einen Alkylrest mit 1 bis 8 C-Atomen oder einen gegebenenfalls substituierten Aryl- oder Aralkylrest bedeuten.

Das aromatische oder heteroaromatische Ringsystem A mit der ortho-ständigen Nitrogruppe kann ein- oder mehrkernig sein. Unter den aromatischen Ringsystemen ist insbesondere das Benzol bevorzugt, wobei der Benzolring ein- oder mehrfach substituiert sein kann, beispielsweise durch $C_1$-$C_8$-Alkyl, insbesondere Methyl, durch $C_1$-$C_6$-Alkoxy, insbesondere Methoxy, durch Halogen, wie Chlor oder Brom, durch Nitro-, Amino-, Monomethylamino-, Dimethylamino-, Nitril- oder Sulfo-Gruppen. Als mehrkernige aromatische Ringsysteme kommen z. B. Naphthalin, Anthracen, Anthrachinon, Phenanthren oder die entsprechenden substituierten Derivate in Betracht. Als heteroaromatisches Ringsystem ist der Pyridinrest bevorzugt. X ist insbesondere ein Wasserstoffatom, der Methyl- oder Ethylrest oder der gegebenenfalls substituierte Phenylrest.

Beispiele für besonders bevorzugte aromatische oder heteroaromatische o-Nitrocarbinole, die den o-Nitrocarbinolestergruppierungen der allgemeinen Formel (I) zugrundeliegen, sind o-Nitrobenzylalkohol, 2-Nitro-6-chlorbenzylalkohol, 2-Nitro-4-cyanobenzylalkohol, 2-Nitro-4,5-dimethoxybenzylalkohol, α-Methyl-o-nitrobenzylalkohol, α-Phenyl-o-nitrobenzylalkohol, α-(o-Nitrophenyl)-o-nitrobenzylalkohol und 2-Nitro-3-hydroxymethylpyridin.

Als Verbindung mit den aromatischen und/oder heteroaromatischen o-Nitrocarbinolestergruppierungen kommen niedermolekulare Ester mit zwei oder mehr Estergruppierungen der allgemeinen Formel (I) in Betracht. Hierzu gehören insbesondere die Di- und/oder Polyester von niedermolekularen Di- und/oder Polycarbonsäuren mit aromatischen und/oder heteroaromatischen o-Nitrocarbinolen der in Rede stehenden Art. Beispiele für niedermolekulare Di- und Polycarbonsäuren, die solchen Estern zugrunde liegen können, sind Oxalsäure, Malonsäure, Adipinsäure, Maleinsäure, Fumarsäure, Crotonsäure, Terephthalsäure, Trimellithsäure und Trimesinsäure.

Werden als lichtempfindliche Komponente niedermolekulare o-Nitrocarbinolestergruppierungen der Formel (I) enthaltende Verbindungen eingesetzt, so enthält die lichtempfindliche Resistschicht vorteilhaft noch ein mit diesen Estern verträgliches polymeres Bindemittel, wobei sich hierfür z. B. Acrylat- und/oder Methacrylat-Polymerisate besonders bewährt haben. Als polymere Bindemittel für die lichtempfindliche Resistschicht kommen auch die nachfolgend beschriebenen hochmolekularen vernetzend wirkenden

Verbindungen mit gegenüber Carboxylgruppen reaktiven Gruppen in Betracht. Im Falle des Einsatzes von niedermolekularen, o-Nitrocarbinolestergruppierungen der Formel (I) enthaltenden Verbindungen als lichtempfindliche Komponente wird deren Menge in der lichtempfindlichen Resistschicht so bemessen, daß die Resistschicht nach der bildmäßigen Belichtung mit den wäßrigen Entwicklerlösungsmitteln auswaschbar ist und daß der angestrebte Vernetzungsgrad bei der thermischen Härtung der Reliefbilder und Resistmuster erreicht wird. Hierzu ist es im allgemeinen hinreichend, wenn in der lichtempfindlichen Resistschicht 2 bis 30 Gew.%, insbesondere 10 bis 15 Gew.%, der aromatischen und/oder heteroaromatischen o-Nitrocarbinolestergruppierungen der Formel (I), berechnet als —COO—, bezogen auf die gesamte lichtempfindliche Resistschicht, enthalten sind.

Besonders bewährt haben sich in dem erfindungsgemäßen Verfahren lichtempfindliche Resistschichten, die als lichtempfindliche Komponente ein Polymeres mit einem Molekulargewicht größer 500 enthalten, welches mindestens 5 Gew.%, bezogen auf das Molekulargewicht des Polymeren, aromatische und/oder heteroaromatische o-Nitrocarbinolestergruppierungen der allgemeinen Formel (I) im Molekül gebunden enthält. Bezüglich dieser Polymeren mit den o-Nitrocarbinolestergruppierungen der Formel (I) sowie deren Herstellung sei insbesondere auf die Angaben in der eingangs zitierten DE-A-21 50 691 verwiesen.

Als das die o-Nitrocarbinolestergruppierungen tragende Polymer kommt zweckmäßigerweise eine organische Polycarbonsäure in Betracht, deren Carboxylgruppen mit den aromatischen und/oder heteroaromatischen o-Nitrocarbinolen verestert sind. Bei den organischen Polycarbonsäuren handelt es sich im allgemeinen um Homopolymere oder Copolymere von ethylenisch ungesättigten Mono- oder Dicarbonsäuren mit 3 bis 6 Kohlenstoffatomen, insbesondere um Homo- oder Copolymerisate von Acrylsäure, Methacrylsäure, Maleinsäure, Fumarsäure oder Crotonsäure. Als Comonomeren kommt dabei Ethylen, Styrol und den $C_1$-$C_8$-Alkylestern der oben genannten ethylenisch ungesättigten Carbonsäuren besondere Bedeutung zu.

Es sei darauf hingewiesen, daß praktisch alle Carboxylgruppen der die o-Nitrocarbinolestergruppierungen tragenden Polycarbonsäure verestert sein oder zumindest in einer Form vorliegen müssen, die mit den reaktiven Gruppen der nachfolgend beschriebenen vernetzend wirkenden Komponente nicht direkt reagieren kann, falls eine gute Lagerstabilität des lichtempfindlichen Resistmaterials, als Lösung oder als Schichtübertragungsmaterial, im Dunkeln oder im Gelblicht gewünscht wird. Anderenfalls besteht nämlich die Gefahr, daß das lichtempfindliche Resistmaterial bereits vor der Belichtung mit aktinischem Licht, z. B. während der Lagerung des Aufzeichnungsmaterials, teilweise vernetzt und härtet, wodurch es für den Einsatz in dem erfindungsgemäßen Verfahren nur mit Einschränkungen geeignet sein würde.

Die Menge an o-Nitrocarbinolestergruppierungen der Formel (I), die in dem Polymeren enthalten sind, wird im allgemeinen nicht unter 5 Gew.%, bezogen auf das Molekulargewicht des Polymeren, liegen und kann in Abhängigkeit von den gewünschten Eigenschaften der lichtempfindlichen Resistschicht und der hieraus hergestellten Reliefbilder oder Resistmuster in weiten Grenzen schwanken. Da bei der Belichtung mit aktinischem Licht die o-Nitrocarbinolestergruppierungen gespalten und freie Carboxylgruppen im Polymeren gebildet werden, wodurch die Löslichkeit des Polymeren geändert wird, ist beispielsweise der Gehalt an o-Nitrocarbinolestergruppierungen der allgemeinen Formel (I) in den Polymeren so zu wählen, daß diese nach der bildmäßigen Belichtung der lichtempfindlichen Resistschicht in wäßrigen Lösungsmitteln, wie z. B. Wasser oder wäßrig-alkalischen Lösungen, löslich oder zumindest dispergierbar sind.

Die in dem erfindungsgemäßen Verfahren einzusetzende lichtempfindliche Resistschicht enthält auch eine vernetzend wirkende Verbindung mit mindestens zwei reaktiven Gruppen, die unter dem Einfluß von Wärme mit —COOH-Gruppen unter Bildung einer kovalenten chemischen Bindung zu reagieren vermögen. Da die Vernetzung und Härtung in dem erfindungsgemäßen Verfahren nach der bildmäßigen Belichtung und Entwicklung der lichtempfindlichen Resistschicht erfolgt, ist die Reaktivität dieser vernetzend wirkenden reaktiven Gruppen so auf die übrigen Verfahrensbedingungen (z. B. Belichtungsdauer der bildmäßigen Belichtung und insbesondere Dauer und Temperatur für die Entwicklung der bildmäßig belichteten Resistschicht) abzustimmen, daß nach der bildmäßigen Belichtung ein einwandfreies Auswaschen der belichteten Schichtanteile mit dem wäßrigen Entwicklerlösungsmittel gewährleistet bleibt. Ist beispielsweise die Zeit zwischen der bildmäßigen Belichtung der lichtempfindlichen Resistschicht und der Entwicklung bzw. die Entwicklungsdauer oder -temperatur im Vergleich zu der Reaktivität der vernetzend wirkenden Verbindungen mit den reaktiven Gruppen zu hoch, so kann es möglich sein, daß die bei der bildmäßigen Belichtung erzeugten Carboxylgruppen bereits vor oder während der Entwicklung mit den vernetzend wirkenden Verbindungen reagieren, so daß dann eine einwandfreie Entwicklung des Reliefbildes oder Resistmusters nicht gewährleistet ist. Es sind daher vorzugsweise solche vernetzend wirkenden Verbindungen in der lichtempfindlichen Resistschicht enthalten, die erst in der Wärme bei erhöhter Temperatur, beispielsweise bei Temperaturen oberhalb 40 °C, in merklicher Geschwindigkeit mit den freien Carboxylgruppen reagieren. Reaktive, vernetzend wirkende Gruppen der in Rede stehenden Art, die für das erfindungsgemäße Verfahren besonders geeignet sind, sind beispielsweise Amin-, Imin-, Amid-, Epoxid-, Hydroxy- und/oder gegebenenfalls verkappte Isocyanat-Gruppen.

Gemäß einer Ausführungsform des erfindungsgemäßen Verfahrens können solche lichtempfindlichen Resistschichten verwendet werden, in denen die aromatischen und/oder heteroaromatischen o-Nitrocarbinolestergruppierungen der allgemeinen Formel (I) sowie die vernetzend wirkenden reaktiven Gruppen der oben genannten Art in ein und demselben Molekül gebunden enthalten sind. Hierbei handelt es sich insbesondere um aromatische und/oder heteroaromatische o-Nitrocarbinolestergruppierungen tragende Copolymerisate, die Comonomere mit den vernetzend wirkenden, reaktiven Gruppen, z. B. Amin-, Imin-, Amid-, Epoxid-, Hydroxy- und/oder gegebenenfalls verkappten Isocyanat-Gruppen, einpolymerisiert enthalten. Als Comonomere mit den vernetzend wirkenden, gegenüber Carboxylgruppen reaktiven Gruppen, die in den die aromatischen und/oder heteroaromatischen o-Nitrocarbinolestergruppierungen der Formel (I) tragenden Polymeren einpolymerisiert sein können, kommen insbesondere solche mit Epoxid-, Hydroxy-, Isocyanat- und/oder verkappten Isocyanat-Gruppen in Betracht. Beispielhaft seien genannt : N,N-Dimethylaminoethyl-(meth)acrylat ; N-Vinylimidazol ; (Meth)-acrylamid sowie vorzugsweise Glycidylester ungesättigter Säuren, insbesondere der Acryl- oder Methacrylsäure, wie Glycidyl-(meth)acrylat ; Glycidylether ungesättigter Alkohole, wie z. B. Allylglycidylether oder 4-Vinylcyclohexendioxid ; Vinylisocyanat, Allylisocyanat ; Monoester von Diolen mit ungesättigten Säuren, insbesondere von Acryl- oder Methacrylsäure, wie z. B. Hydroxyethyl-(meth)acrylat, Hydroxypropyl-(meth)acrylat oder Butandiol-mono-(meth)acrylat ; und Methylolverbindungen vom Amoltyp, z. B. N-Methylolacrylamid.

Gemäß einer anderen Ausführungsform der Erfindung können die vernetzend wirkenden Verbindungen mit den reaktiven Gruppen zusätzlich zu der Verbindung mit den aromatischen und/oder heteroaromatischen o-Nitrocarbinolestergruppierungen in der lichtempfindlichen Resistschicht enthalten sein. In diesem Fall kann es sich bei den vernetzend wirkenden Verbindungen sowohl um höhermolekulare Verbindungen, wie z. B. entsprechende Polymere, oder um entsprechende niedermolekulare Verbindungen handeln. Wenn die vernetzend wirkenden Verbindungen mit den reaktiven Gruppen als Zumischkomponente in die lichtempfindliche Resistschicht eingebracht werden, sollen sie mit der die aromatischen und/oder heteroaromatischen o-Nitrocarbinolestergruppierungen enthaltenden Verbindung verträglich sein. Bevorzugte Klassen von vernetzend wirkenden Verbindungen mit zwei oder mehr der reaktiven Gruppen, die als Zumischkomponente in der lichtempfindlichen Schicht enthalten sein können, sind Di- oder Polyepoxide, freie oder verkappte Di- oder Polyisocyanate, Carbodiimide, Di- oder Polyhydroxide sowie Di- oder Polyamine. Die lichtempfindliche Resistschicht kann dabei nur eine oder auch mehrere der vernetzend wirkenden Verbindungen enthalten. Beispielsweise ist es möglich, daß die lichtempfindliche Resistschicht zwei oder mehr verschiedenartige vernetzend wirkende Verbindungen, wie Epoxide, Isocyanate und/oder verkappte Isocyanate, enthält.

Die Di- oder Polyepoxide umfassen die Umsetzungsprodukte von Epichlorhydrin mit Polyolen, die Umsetzungsprodukte von Epichlorhydrin mit Polyaminen, Polyolefinepoxide, epoxidiertes Polybutadien, Epoxiharze vom Novolaktyp, Hochpolymere von Glycidylestern ungesättigter Carbonsäuren, insbesondere der (Meth)acrylsäure, und andere. Von besonderem Interesse sind die Epoxide auf Basis von Epichlorhydrin und Bisphenol A. Durch Substitution des Bisphenol A können die Eigenschaften dieser Epoxide beeinflußt werden ; beispielsweise wird erhöhte Flammwidrigkeit erzielt, wenn Epoxide auf Basis von halogeniertem Bisphenol A, wie z. B. Tetrabrombisphenol A oder Tetrachlorbisphenol A, eingesetzt werden. Eine andere Gruppe von geeigneten Epoxiden sind diejenigen, in denen die endständigen Glycidylgruppen durch aliphatische oder araliphatische Reste verbunden sind. Ein typischer Vertreter dieser Klasse ist der Diglycidylether des 1,4-Butandiols. Derartige Epoxide führen beispielsweise wegen des weniger starren Molekülaufbaus zu flexibleren Härtungsprodukten. Werden Amine anstelle der mehrwertigen Alkohole mit Epichlorhydrin zur Herstellung der Epoxidverbindungen herangezogen, so erhält man Epoxidpropylamine, die im Aufbauprinzip den Glycidylethern ähnlich sind. Ein typischer Vertreter hierfür ist das Bis(epoxipropyl)anilin, welches aufgrund seiner äußerst niedrigen Viskosität als bifunktioneller Verdünner eingesetzt werden kann. Als hochmolekulare vernetzend wirkende Verbindung sind u. a. die Epoxiharze vom Novolaktyp von Interesse. Aufgrund ihrer hohen Funktionalität ergeben sie mit den photochemisch erzeugten Carbonsäure-Gruppen hochvernetzte Systeme mit hoher Wärmeformbeständigkeit.

Durch Einsatz von cycloaliphatischen Epoxiden, die in ihrem Molekül ein oder mehrere cycloaliphatische Ringe, jedoch keine aromatischen Ringe enthalten, kann z. B. die Lagerstabilität und UV-Beständigkeit erhöht werden. Bei den cycloaliphatischen Epoxiden kann der Epoxidsauerstoff ausschließlich an die cycloaliphatischen Ringe gebunden sein, wie z. B. im Dicyclopentadiendioxid, er kann ausschließlich in den Seitenketten gebunden sein, wie z. B. beim Diglycidylester der Hexahydrophthalsäure, oder er kann sowohl an den cyclischen Ringen als auch an die Seitenkette gebunden sein, wie z. B. beim Vinylcyclohexandioxid.

Weiterhin kommen als vernetzend wirkende Verbindungen die üblichen Polyisocyanate mit zwei oder mehr Isocyanatgruppen pro Molekül in Betracht, z. B. Alkyl- und Cycloalkyldiisocyanate mit vorzugsweise 4 bis 41 Kohlenstoffatomen im Alkyl- bzw. Cycloalkylrest, wie z. B. Dimersäurediisocyanat, Isophorondiisocyanat, Dicyclohexylmethandiisocyanat, 1,4-Butandiisocyanat, Hexamethylendiisocyanat, Heptadecandiisocyanat, 2,2,4-Trimethylhexamethylendiisocyanat, 2,6-Diisocyanatomethylcaproat, Isocyanuratisocyanate, z. B. das Produkt aus der Umsetzung von 2,4-Toluylendiisocyanat mit Hexamethylendiisocyanat, Biurete, wie Hexamethylendiisocyanatbiuret, Aryldi- und -triisocyanate, wie z. B. Toluylendiisocyanat, Diphenylmethandiisocyanat, Naphthylendiisocyanat, Triphenylmethantriisocyanat, Xylylendiisocyanat,

gemischte aliphatisch-aromatische Di- und Triisocyanate, funktionelle Gruppierungen enthaltende Di- und Triisocyanate, wie z. B. Carbonylisocyanate, wie Carbonyldiisocyanat oder Isophthaloyldiisocyanat, Sulfarylisocyanate, Sulfonyldiisocyanat, oder m-Phenylendisulfonyldiisocyanat, Allophanatisocyanate, Heteroatome enthaltende Di- und Triisocyanate, wie z. B. Umsetzungsprodukte aus Hexamethylcyclotrisilazan und Diphenylmethandiisocyanat, sowie Isocyanatgruppen enthaltende Polymere, z. B. Mischpolymerisate des Vinylisocyanats, Hydroxylgruppen und/oder Aminogruppen enthaltende Polymerisate oder Polykondensate, die mit einem Überschuß an Di- oder Triisocyanaten umgesetzt worden sind.

Da die lichtempfindliche Resistschicht in dem erfindungsgemäßen Verfahren erst durch Lichteinwirkung in den Zustand der thermischen Härtbarkeit gebracht wird, braucht die Isocyanatkomponente nicht verkappt zu sein, um eine sehr hohe Lagerstabilität des lichtempfindlichen Resistmaterials vor der Verarbeitung in dem erfindungsgemäßen Verfahren zu erreichen. Sofern in dem erfindungsgemäßen Verfahren jedoch ein großer Verarbeitungsspielraum zwischen dem bildmäßigen Belichten der lichtempfindlichen Resistschicht und dem Entwickeln gewünscht wird, z. B. insbesondere dann, wenn diese Prozeßschritte nicht automatisiert hintereinander ablaufen, werden vorteilhaft verkappte Isocyanate als vernetzend wirkende Komponente in der lichtempfindlichen Resistschicht verwendet. Da sich die verkappten Isocyanate bei erhöhter Temperatur wieder in die Ausgangskomponenten spalten, ist bei Einsatz von verkappten Isocyanaten als vernetzend wirkenden Verbindungen nach der bildmäßigen Belichtung die lichtempfindliche Schicht bei Raumtemperatur völlig indifferent und besitzt somit einen sehr hohen Verarbeitungsspielraum, während beim Erwärmen unter Abspaltung der schützenden Komponente die wieder freigelegten Isocyanatgruppen mit den photochemisch erzeugten Carbonsäuregruppen reagieren und dadurch eine Vernetzung und Härtung der belichteten Resistschicht bewirken.

Als schützende Komponente für die Verkappung der Isocyanate kommen hauptsächlich Phenole, Acetonoxim, Methylethylketoxim, Acetessigester oder Malonester in Frage; es eignen sich jedoch ebenfalls Verbindungen wie Acetylaceton, Phthalimid, Caprolactam, Benzolsulfonamid und 2-Mercaptobenzthiazol. Eine gut geeignete, hoch wirksame verkappte Isocyanatverbindung erhält man beispielsweise aus einem Mol Trimethylolpropan, 3 Mol 2,4-Diisocyanatotoluol und 3 Mol Phenol. Als weiteres Beispiel für ein verkapptes Isocyanat sei das Isocyanuratderivat genannt, welches durch Trimerisierung des Umsetzungsproduktes von 2,4-Diisocyanatotoluol und Kresol erhalten wird. Ebenfalls hervorragend als vernetzend wirkende Verbindung geeignet sind die aus Toluylendiisocyanat, Trimethylolpropan, Butandiol und Kresol hergestellten verkappten Isocyanate.

Eine weitere Gruppe von sehr geeigneten vernetzend wirkenden Verbindungen sind wegen ihrer leichten Reaktion mit Carbonsäure-Gruppen die bekannten und üblichen Carbodiimide, wie sie durch Carbodiimidisierung von Diisocyanaten entstehen. Werden als vernetzend wirkende Verbindung α,ω-Diisocyanato-polycarbodiimide eingesetzt, erhält man bei der erfindungsgemäßen Härtung der Resistschicht ein dichtes Netzwerk unter Ausbildung von Poly-acylharnstoff. Die Carbodiimide können sowohl aus aromatischen, als auch aus aliphatischen Diisocyanaten aufgebaut sein. α,ω-Diisocyanato-polycarbodiimide aus Isophorondiisocyanat sind in dem erfindungsgemäßen Verfahren als vernetzend wirkende Verbindung u. a. deswegen besonders gut geeignet, da sie als verkapptes Polyisocyanat einen hohen Verarbeitungsspielraum zwischen bildmäßigem Belichten der lichtempfindlichen Resistschicht und dem Entwickeln gewährleisten.

Vorteilhafte vernetzend wirkende Verbindungen mit mindestens zwei reaktiven Gruppen sind ferner Polymere, die Hydroxy- oder Amino-Gruppen eingebaut enthalten. Erwähnt seien z. B. Phenol-formaldehydharze, Harnstofformaldehydharze und Melamin-formaldehydharze. Besonders geeignete Verbindungen aus dieser Klasse sind die Novolake.

Die hochmolekularen vernetzend wirkenden Verbindungen mit den reaktiven Gruppen, beispielsweise des letztgenannten Types oder die Glycidylgruppen oder Isocyanatgruppen enthaltenden Polymere, werden in den lichtempfindlichen Resistschichten bevorzugt dann verwendet, wenn die in der lichtempfindlichen Resistschicht enthaltenen Verbindungen mit den o-Nitrocarbinolestergruppierungen ein relativ niedriges Molekulargewicht besitzen, und können dann, wie bereits erwähnt wurde, als polymeres Bindemittel für die lichtempfindliche Resistschicht dienen. Wenn o-Nitrocarbinolestergruppierungen tragende Polymere mit hohem Molekulargewicht in der lichtempfindlichen Resistschicht enthalten sind, können die zugesetzten vernetzend wirkenden Verbindungen mit den reaktiven Gruppen je nach gewünschtem Verwendungszweck und angestrebtem Eigenschaftsbild niedermolekular oder auch hochmolekular sein.

Das Verhältnis der reaktiven Gruppen in den vernetzend wirkenden Verbindungen zu den o-Nitrocarbinolestergruppierungen der allgemeinen Formel (I) in den diese Gruppierungen enthaltenden Verbindungen richtet sich in Abhängigkeit von der Art der eingesetzten Komponenten insbesondere nach dem angestrebten Eigenschaftsbild der lichtempfindlichen Resistschicht bzw. der hieraus hergestellten Reliefbilder oder Resistmuster. Es kann daher in weiten Grenzen variiert werden, ist jedoch auf alle Fälle so zu wählen, daß der gewünschte Vernetzungs- und Härtungsgrad in den Reliefbildern und Resistmustern erzielt wird. Wird auf eine starke Vernetzung bei der Härtung Wert gelegt, so werden im allgemeinen sehr reaktive vernetzend wirkende Verbindungen vorzugsweise im Überschuß in Bezug auf die o-Nitrocarbinolestergruppierungen eingesetzt. Ist eine weniger starke Vernetzung hinreichend, so können die vernetzend wirkenden Verbindungen sowohl bezüglich Menge als auch Reaktivität entsprechend reduziert werden.

Die in dem erfindungsgemäßen Verfahren eingesetzten lichtempfindlichen Resistschichten können neben den Verbindungen mit den o-Nitrocarbinolestergruppierungen und den Verbindungen mit den vernetzend wirkenden, reaktiven Gruppen sowie gegebenenfalls den polymeren Bindemitteln darüber hinaus weitere übliche und an sich bekannte Zusatz- und Hilfsstoffe enthalten. Bei diesen Zusatz- und Hilfsstoffen kann es sich einerseits um Verbindungen handeln, die zur Vereinfachung der Herstellung der lichtempfindlichen Resistschicht bzw. des Aufzeichnungsmaterials zugesetzt worden sind. Hierzu gehören beispielsweise Weichmacher oder Verlaufsmittel. Weichmacher werden in die lichtempfindliche Resistschicht insbesondere dann eingearbeitet, wenn diese in trockenem Zustand, insbesondere durch Laminieren, auf den permanenten Träger aufgebracht werden soll. Beispiele für weichmachende Verbindungen, die mit den die o-Nitrocarbinolestergruppierungen enthaltenden Verbindungen, insbesondere den Polymeren, verträglich sein sollen, sind Trikresylphosphat, n-Butyl-benzylphthalat und flüssige Polyester aus aliphatischen Dicarbonsäuren und bifunktionellen Glykolen, insbesondere Polyester aus Adipinsäure und 1,2-Propylenglykol oder 1,4-Butandiol mit einer Viskosität von 1 000 bis 15 000 cP. Werden als vernetzend wirkende Verbindungen mit mindestens zwei reaktiven Gruppen niedermolekulare Substanzen als Zumischkomponente eingesetzt, so können diese auch als Weichmacher wirken und den Zusatz von gesonderten weichmachenden Verbindungen teilweise oder vollständig überflüssig machen. Verlaufsmittel, wie z. B. Silikonöle, sind insbesondere dann empfehlenswert, wenn die lichtempfindliche Resistschicht durch Gießen aus Lösung auf einen Träger aufgebracht werden soll.

Andererseits können die lichtempfindlichen Resistschichten solche Zusatzstoffe enthalten, die die anwendungstechnischen Eigenschaften der lichtempfindlichen Resistschicht verbessern oder modifizieren. Hierzu gehören beispielsweise Katalysatoren, die die thermische Härtung der belichteten Resistschicht, d. h. also die Umsetzung zwischen den freien Carboxylgruppen und den reaktiven Gruppen der vernetzend wirkenden Verbindungen beschleunigen ; Sensibilisatoren, die die Lichtempfindlichkeit und die spektrale Empfindlichkeit der lichtempfindlichen Resistschicht verbessern ; Farbstoffe, Pigmente und/oder photochrome Substanzen.

Als Katalysatoren für die thermische Härtung der belichteten Resistschicht können je nach Art der verwendeten vernetzend wirkenden Verbindung die für solche Reaktionen an sich bekannten Säuren und Basen eingesetzt werden. Es ist allerdings dabei zu beachten, daß sich damit der Verarbeitungsspielraum zwischen der bildmäßigen Belichtung der lichtempfindlichen Resistschicht und deren Entwicklung einengt, so daß die Menge der Katalysatoren im allgemeinen gering gehalten wird. Teilweise ist bereits der Zusatz von Katalysatormengen im ppm-Bereich hinreichend. Als Beispiele für Katalysatoren seien genannt : Benzyldimethylamin, Benzyltrimethylammoniumhydroxid, Diazabicyclooctan, N,N,N',N'-Tetramethyl-1,3-diaminobutan, 2-Dimethylamino-2-hydroxypropan, 2-Diethylaminomethylphenol, 2,4,5-Tri(dimethylaminoethyl)-phenol, zinnorganische Verbindungen, wie Zinnoctoat u. a.

Beispiele für Sensibilisatoren sind : Xanthen-Farbstoffe, wie Fluoreszein, Eosin und Rhodamin S, sowie Triplet-Energieüberträger, wie sie beispielsweise N. J. Turro in seinem Buch « Moleculare Photochemistry », W. A. Benjamin Inc., New York 1967, auf Seite 132 beschreibt. Als Farbstoffe, die in der lichtempfindlichen Resistschicht enthalten sein können, haben sich u. a. Sudanfarbstoffe, Polymethin-Farbstoffe, Azofarbstoffe, Phthalocyanin-Farbstoffe oder Dispersionsfarbstoffe sowie Eosin, Kristallviolett oder Malachitgrün bewährt. Besonders vorteilhaft sind solche Farbstoffe, die bei der Belichtung mit aktinischem Licht ihre Färbung reversibel oder irreversibel ändern. So werden z. B. Sudanfarbstoffe, Polymethinfarbstoffe oder Azofarbstoffe durch zugesetzte Photoinitiatoren, wie Benzoinether, Benzilketale, Benzophenon oder Michler's Keton in der lichtempfindlichen Schicht entsprechend der bildmäßigen Belichtung ausgebleicht. Besonders erwähnt seien die Polymethinfarbstoffe der allgemeinen Formel (II)

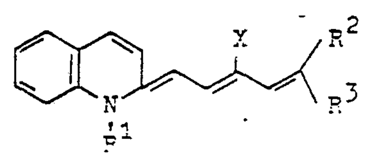

(II)

worin bedeuten

$R^1$ Alkyl,
$R^2$ —CN,
$R^3$ —CN, —$COOR^4$, —Ph—$R^5$,
$R^4$ Alkyl,
$R^5$ —$NO_2$, Halogen, Alkyl, Alkoxy und
X Halogen.

Bei dem erfindungsgemäßen Verfahren wird die lichtempfindliche Resistschicht zunächst auf den permanenten Träger aufgebracht, auf dem die Reliefbilder oder Resistmuster gebildet werden sollen. Dies kann, wie bereits weiter oben erwähnt wurde, beispielsweise durch Gießen der lichtempfindlichen Schicht aus Lösung geschehen. Man kann aber auch die lichtempfindliche Schicht zunächst auf einen

temporären Träger aufbringen und die im allgemeinen trockene und feste lichtempfindliche Resistschicht dann nach dem Schichtübertragungsverfahren auf den permanenten Träger unter Anwendung von Druck und/oder Wärme auflaminieren. Die Schichtdicke der lichtempfindlichen Resistschicht hängt von der jeweiligen Anwendung ab. Da sich das erfindungsgemäße Verfahren insbesondere für die Anwendung in der Dünnschicht-Technologie eignet, liegen die Schichtdicken der lichtempfindlichen Resistschicht im allgemeinen im Bereich von 0,1 bis 100 µm ; für den Einsatz als Lötstoppmaske sind Schichtdicken des Resists bis 2 000 µm möglich.

In einer besonderen Ausführungsform des erfindungsgemäßen Verfahrens wird die im allgemeinen trockene und feste lichtempfindliche Resistschicht zunächst auf einem temporären Schichtträger, z. B. einer Polyesterfolie, erzeugt und vor dem Aufbringen auf den permanenten Träger, der das Substrat für die Reliefbilder und Resistmuster darstellt, kurzzeitig vollflächig mit aktinischem Licht vorbelichtet. Diese Vorbelichtung geschieht bevorzugt von der Seite der lichtempfindlichen Resistschicht her, die später auf den permanenten Träger aufgebracht wird, und kann bis zu 70 % der Zeit für die nachfolgende bildmäßige Hauptbelichtung betragen. Diese Vorbelichtung führt nicht nur zu einer verbesserten Haftung der lichtempfindlichen Resistschicht auf dem permanenten Träger, insbesondere metallischen oder metalloxidischen Untergründen, sondern überraschenderweise auch zu einer Erhöhung der Lichtempfindlichkeit der Resistschicht bei der bildmäßigen Belichtung und zu einer Verringerung der Entwicklungszeit nach der bildmäßigen Belichtung, ohne daß hierdurch etwa die originalgetreue und exakte Wiedergabe des übertragenen Bildes bei der Herstellung der Reliefbilder oder Resistmuster in irgendeiner Weise nachteilig beeinflußt wird. Dadurch, daß diese Vorbelichtung durch eine Lichtstrecke entweder während der Herstellung des Schichtübertragungsmaterials oder während des Laminierens unmittelbar vor dem Aufbringen der lichtempfindlichen Schicht auf den permanenten Träger vorgenommen werden kann, läßt sich diese Verfahrensvariante ohne besondere zusätzliche Aufwendungen oder Verarbeitungsschritte durchführen.

Die auf den permanenten Träger, der den Untergrund für die Reliefbilder oder Resistmuster darstellt, aufgebrachte lichtempfindliche Resistschicht wird erfindungsgemäß zunächst mit aktinischem Licht durch eine geeignete und entsprechende Bildvorlage in an sich bekannter Weise bildmäßig belichtet. Geeignete Lichtquellen hierfür sind solche, die aktinisches Licht im Wellenlängenbereich von 200 bis 600 nm, vorzugsweise im Bereich von 300 bis 420 nm, ausstrahlen, also z. B. Kohlebogenlampen, Quecksilberhochdrucklampen, Xenonhochdrucklampen und insbesondere Quecksilberniederdruckfluoreszenzlampen. Die Belichtungszeiten für die bildmäßige Belichtung, die insbesondere von der Art und der Dicke der lichtempfindlichen Resistschicht abhängen, liegen im allgemeinen im Bereich von etwa 0,05 bis 50 min. und richten sich auch nach der Stärke der verwendeten Lichtquelle.

Nach der bildmäßigen Belichtung der lichtempfindlichen Resistschicht, bei der in den belichteten Bereichen die o-Nitrocarbinolestergruppierungen unter Bildung von freien Carboxylgruppen gespalten werden, werden die belichteten Schichtanteile mit einem wäßrigen Entwickler-Lösungsmittel ausgewaschen. Bei dem Entwickler-Lösungsmittel kann es sich um Wasser als solches oder auch um Mischungen von Wasser mit wasserlöslichen, organischen Lösungsmitteln handeln, beispielsweise um Gemische von Wasser mit aliphatischen Alkoholen, insbesondere Methanol oder Ethanol ; Ketonen, wie z. B. Aceton ; oder cyclischen Ethern, z. B. Tetrahydrofuran. Insbesondere wird als Entwicklerlösungsmittel Wasser eingesetzt. Der pH-Wert des Entwickler-Lösungsmittels ist zweckmäßig größer als 7,5, wodurch wenigstens ein Teil der freien Carboxylgruppen in die Salzform übergeführt wird. Die optimale Alkalimenge bzw. der pH-Wert ist dabei natürlich abhängig von dem verwendeten Schichtmaterial und der Belichtungsdauer und -intensität, d. h. also der Menge der bei der bildmäßigen Belichtung gebildeten freien Carboxyl-Gruppen. Als Alkalien für das Entwickler-Lösungsmittel können z. B. Zusätze von Borax, Dinatriumhydrogenphosphat, Soda, Alkalihydroxiden oder von organischen Basen, wie Di- oder Triethanolamin verwendet werden. Der Auswaschlösung können auch Zusätze wie beispielsweise oberflächenaktive Substanzen, Natriumcarboxymethylcellulose, Polyvinylalkohol, Polynatriumacrylat und dgl. zugegeben werden.

Im übrigen sind die Bedingungen (z. B. Dauer und Temperatur) für die Entwicklung der bildmäßig belichteten Resistschicht auf den vorhandenen Verarbeitungsspielraum abzustellen. Da die lichtempfindliche Resistschicht vernetzend wirkende Verbindungen enthält, die mit den bei der Belichtung gebildeten freien Carboxylgruppen zu reagieren vermögen, andererseits jedoch die Entfernung der belichteten Schichtanteile bei der Entwicklung vollständig bis auf den Träger und unter Ausbildung von scharfen Konturen erfolgen soll, wird die Entwicklung in aller Regel unmittelbar im Anschluß an die bildmäßige Belichtung der lichtempfindlichen Resistschicht vorgenommen. Das Auswaschen der belichteten Schichtanteile kann dabei in üblicher Weise, beispielsweise durch Besprühen, Ausreiben oder Ausbürsten mit dem wäßrigen Entwickler-Lösungsmittel geschehen. Zur Beschleunigung des Entwicklungs-Vorgangs können, in Abhängigkeit von der in der lichtempfindlichen Schicht enthaltenen vernetzend wirkenden Verbindung, erhöhte Temperaturen, beispielsweise bis etwa 40 °C, angewandt werden. Die Entwicklungsdauer liegt im allgemeinen im Bereich von einigen Minuten.

In einer besonderen Ausführungsform des erfindungsgemäßen Verfahrens wird die lichtempfindliche Resistschicht vor der abschließenden vollflächigen Nachbelichtung und thermischen Härtung mehrmals wechselweise bildmäßig belichtet und entwickelt. Vor der zweiten sowie gegebenenfalls jeder weiteren bildmäßigen Belichtung können die durch die Entwicklung freigelegten bereiche des Trägers beispielsweise durch Ätzen oder galvanische Metallabscheidung modifiziert werden. Diese Möglichkeit der bildmäßigen Mehrfachbelichtung eröffnet insbesondere bei der Herstellung von gedruckten Schaltungen neue Anwendungsmöglichkeiten.

Nach dem Entfernen der bildmäßig belichteten Teile der Resistschicht wird erfindungsgemäß, sofern keine weitere bildmäßige Belichtung mehr folgt, der auf dem Träger verbliebene Teil der lichtempfindlichen Resistschicht, der nunmehr bereits ein positives Abbild der bildmäßigen Vorlage darstellt, vollflächig mit aktinischem Licht nachbelichtet. Für diese vollflächige Nachbelichtung können die gleichen Lichtquellen herangezogen werden, wie für die vorerwähnte bildmäßige Belichtung. Die Dauer dieser vollflächigen Nachbelichtung liegt im allgemeinen im Bereich von 0,05 bis 50 min und richtet sich insbesondere nach dem gewünschten Härtungsgrad und somit dem angestrebten Eigenschaftsbild der Reliefbilder und Resistmuster. Die vollflächige Nachbelichtung wird daher ganz allgemein mit einer solchen Intensität und für eine solche Dauer durchgeführt, daß sich hierdurch in der bildmäßig belichteten und entwickelten lichtempfindlichen Resistschicht eine für die Härtung hinreichende Anzahl von freien Carboxylgruppen bildet.

Im Anschluß an die vollflächige Nachbelichtung wird die Resistschicht thermisch vernetzt und gehärtet. Die thermische Vernetzung kann beispielsweise bei Raumtemperatur erfolgen, jedoch sind dann im allgemeinen sehr lange Härtungszeiten notwendig. Vorteilhafterweise wird daher die Härtung bei erhöhten Temperaturen durchgeführt, indem man die nachbelichtete Resistschicht auf Temperaturen im Bereich von vorzugsweise 50 bis 250 °C, insbesondere 60 bis 200 °C, erwärmt. Die Dauer für die Nachhärtung, die im Bereich von etwa 10 min. bis einigen Stunden, z. B. 5 Stunden liegen kann, ist u. a. abhängig von der Art und Reaktivität der eingesetzten vernetzend wirkenden Verbindung, der Anzahl der bei der vollflächigen Nachbelichtung erzeugten freien Carboxylgruppen, dem gewünschten Vernetzungs- und Härtungsgrad, der Schichtdicke etc. Beispielsweise erfordert die Vernetzung der freien Carboxylgruppen mit Epoxidverbindungen relativ hohe Härtungstemperaturen. So muß man beispielsweise ein äquimolares unkatalysiertes Gemisch aus Carbonsäure und einem Diepoxid aus 2,2-Bis-(p-hydroxyphenyl)-propan, 2 bis 4 Stunden auf etwa 150 bis 200 °C erhitzen, um alle Epoxidgruppen umzusetzen. Man kann die Härtung, beispielsweise unter Einsatz eines Überschusses oder auch Unterschusses an Epoxidverbindungen bzw. allgemein den vernetzend wirkenden Verbindungen, auch stufenweise vornehmen, indem man beispielsweise zunächst auf Temperaturen bis etwa 150 °C erwärmt und anschließend bei Temperaturen über 150 °C, insbesondere bei einer Temperatur um 200 °C oder darüber endgültig aushärtet.

Durch das erfindungsgemäße Verfahren erhält man Reliefbilder oder Resistmuster mit einer insbesondere bei kurzfristigen thermischen Belastungen großen Temperaturbeständigkeit, je nach Komponente beispielsweise bis oberhalb 270 °C, ausgezeichneten mechanischen Eigenschaften, hoher Abriebfestigkeit, hoher Durchschlags- und Kriechstomfestigkeit, sowie stark verbesserter Resistenz gegen aggressive Prozeßchemikalien, insbesondere starken Säuren und Laugen, wie sie bei der Weiterverarbeitung der Reliefbilder oder Resistmuster zur Anwendung kommen können.

Das erfindungsgemäße Verfahren bzw. die hiernach hergestellten Reliefbilder und Resistmuster finden u. a. Verwendung zur Herstellung von Dickschichtschaltungen, Dünnschichtschaltungen, z. B. für die Hochfrequenztechnik, von integrierten Schaltungen, allgemein von Halbleitern, von gedruckten Schaltungen und Lötstoppmasken sowie zur Herstellung von Offset-Druckplatten. Die Techniken zur Herstellung gedruckter Schaltungen und Offset-Druckplatten sind dabei als solche hinreichend bekannt. Gewünschtenfalls kann das erfindungsgemäß hergestellte Resistmuster z. B. nach der Modifizierung der freigelegten Bereiche des Trägers vom Träger entfernt werden, etwa durch Strippen mit einem geeigneten Lösungsmittel wie Methylenchlorid.

In der Dünnschichttechnologie werden z. B. zur Herstellung von Dünnschichtschaltungen als Basismaterial Keramiksubstrate verarbeitet, die wegen ihrer dielektrischen Eigenschaften sowie ihrer thermischen und chemischen Stabilität herausragende Eigenschaften haben. In mehreren Verarbeitungsschritten werden metallische und/oder metalloxidische Schichten von z. B. 0,01 bis 1 µm Dicke übereinander flächig aufgedampft oder aufgespattert. In der strukturierten Form übernehmen diese Schichten die Funktionen von Ohm'schen Widerständen, Kondensatoren, Induktivitäten, Gleichrichtern, optoelektronischen Anzeigen, haftvermittlern, Leiterbahnen, Supraleitern, Isolierschichten usw. Zur Strukturierung dieser dünnen Schichten ist das erfindungsgemäße Verfahren äußerst geeignet, indem die lichtempfindliche Resistschicht auf die Substrate in einer Schichtdicke zwischen 0,1 und 50 µm, bevorzugt 3 und 10 µm, aufgetragen, bildmäßig entsprechend der gewünschten Strukturierung belichtet, entwickelt, vollflächig nachbelichtet und anschließend thermisch gehärtet wird. Die freigelegten Substratoberflächen, wie Metall(oxid)-Schichten, können dann durch Dotierung, Ätzung oder galvanische Metallablagerung weiterbehandelt werden. Dabei sind die erfindungsgemäß hergestellten Resistmuster auch bei erhöhter Temperatur gegen sehr aggressive Ätz- und Galvanisierbäder (wie beispielsweise konzentrierte Salpetersäure oder ammoniakalische Kupfer(II)chlorid-Lösung) beständig. Neben dem Naßätzen können die erfindungsgemäß hergestellten Resistmuster auch zur Plasma-Trocken-Ätzung mit erhöhter Temperatur (> 100 °C), wie sie auch als Reinigungsschritt in der Halbleitertechnik eingesetzt wird, verwendet werden.

In der Halbleitertechnik ist das Basismaterial z. B. eine 0,5 mm dicke Silicium-Scheibe, die mit einer Metalloxidschicht versehen ist. Die Erzeugung aktiver Bauelemente, wie Transistoren, Dioden und ihre

Verbindungen durch Leiterbahnen, ist in der einschlägigen Literatur näher beschrieben und braucht daher hier nicht näher erläutert zu werden. Zur Strukturerzeugung nach dem erfindungsgemäßen Verfahren werden hierbei im allgemeinen lichtempfindliche Resistschichten einer Dicke von 0,01 bis 50 μm, bevorzugt 0,5 bis 5 μm verwendet, wobei ohne weiteres die heute geforderte Auflösung von weniger als 10 μm erzielt wird.

Wegen der hervorragenden Eigenschaften des Endproduktes eignet sich das erfindungsgemäße Verfahren mit Vorteil auch zur Herstellung von Lötstoppmasken, indem die lichtempfindliche Resistschicht z. B. auf die zu verarbeitende, das Schaltbild enthaltende Oberfläche einer Leiterplatte aufgebracht und durch eine Photomaske an den Stellen der freizulegenden Lötaugen belichtet wird. Das Aufbringen der lichtempfindlichen Resistschicht erfolgt dabei vorteilhaft durch Laminieren nach dem Schichtübertragungsverfahren. Nach Freilegen der Lötaugen durch Auswaschen der belichteten Resistschicht mit dem Entwicklerlösungsmittel, vollflächigem Nachbelichten und thermischen Härten erfüllt die verbleibende Resistschicht alle Anforderungen, die an eine Lötstoppmaske gestellt werden. Bei der Herstellung von Lötstoppmasken mit dem erfindungsgemäßen Verfahren kann insbesondere auch die oben erwähnte Möglickeit der mehrfachen bildmäßigen Belichtung ausgenutzt werden, indem die auf dem zu behandelnden Träger aufgebrachte lichtempfindliche Resistschicht zunächst bildmäßig entsprechend den gewünschten Leiterbahnen belichtet wird, die nach dem Entwickeln freigelegten Bereiche des Trägers durch Ätzen oder galvanisches Metallabscheiden unter Ausbildung der Leiterbahnen modifiziert werden, danach durch weiteres bildmäßiges Belichten und Auswaschen die Löcher der gedruckten Schaltung bzw. die Lötaugen freigelegt werden, worauf anschließend die Resistschicht vollflächig nachbelichtet und gehärtet wird.

In einer speziellen Verfahrensvariante insbesondere zur Herstellung einer Lötstoppmaske für Leiterplatten oder gedruckte Schaltungen kann die bildmäßige Belichtung ohne Verwendung eines besonderen Maskenfilms erfolgen, wenn die gelochte Leiterplatte die Funktion der Photomakse übernimmt.

Hierzu wird die auf die gelochte Leiterplatte aufgebrachte lichtempfindliche Resistschicht von der Gegenseite durch die Löcher der Leiterplatte belichtet. Vorteilhafterweise wird bei der Belichtung durch die Löcher auf die freie, von der Leiterplatte abgewandte Oberfläche der lichtempfindlichen Resistschicht eine Streufolie oder ein Spiegel, z. B. eine feingebürstete Aluminiumplatte, gelegt, insbesondere wenn die verwendete Lichtquelle einen hohen Anteil an nicht-parallelem Licht besitzt. Hierdurch wird erreicht, daß die lichtempfindliche Resistschicht im Lochbereich gleichmäßiger ausgeleuchtet wird und somit die Löcher in der Resistschicht exakt abgebildet werden. Bei dieser Variante des erfindungsgemäßen Verfahrens werden in der Resistschicht nur die Bereich der Löcher entfernt, so daß die Lötaugen, d. h. die leitfähigen Höfe um das Loch, weiterhin geschützt sind. Dies ist auf der Bestückungsseite der Leiterplatte erwünscht oder auch, wenn lötfreie Bestückungsverfahren, z. B. mittels Steckkontakten angewandt werden. Im letztgenannten Fall ist die filmlose Verfahrensvariante auch auf beiden Seiten der Leiterplatte einsetzbar.

Die Erfindung wird durch die nachfolgenden Beispiele näher erläutert. Die in den Beispielen angegebenen Teile und Prozente beziehen sich, soweit nicht anders vermerkt, auf das Gewicht.

## Beispiel 1

72 Teile eines Methylmethacrylat-Copolymerisats, welches 35 % o-Nitrobenzylacrylat enthiet, 27 Teile eines Bisphenol-A-diglycidylethers (Epikote(R) 828 der Fa. Shell), 0,7 Teile Benzildimethylketal, 0,1 Teile eines schwarzen Farbstoffes und 0,2 Teile des Polymethinfarbstoffes der allgemeinen Formel (II), worin $R^1$ eine Methylgruppe, $R^2$ eine Nitrilgruppe, $R^3$ eine —COOEt-Gruppe und X Chlor darstellt, wurden in 160 Volumen-Teilen Essigsäureethylester gelöst. Aus dieser Lösung wurde auf eine Polyethylenterephthalatfolie (temporärer Träger) eine lichtempfindliche Schicht so gegossen, daß nach Entfernung des Lösungsmittels und Trocknung eine Schichtdicke von etwa 10 μm resultierte. Die freie Oberfläche der so hergestellten lichtempfindlichen Resistschicht wurde bei 100 °C mit einer Geschwindigkeit von 0,5 m pro Minute auf ein aluminiumbedampftes Glas auflaminiert. Die lichtempfindliche Resistschicht wurde mittels einer photographischen Positiv-Vorlage durch die Polyethylenterephthalat-Folie hindurch mit einer 500 W Höchstdruckquecksilber-Lampe 25 Minuten bildmäßig belichtet. Anschließend wurde die Polyethylenterephthalat-Folie abgezogen und die belichteten Schichtanteile, die sich bei der Belichtung entfärbt hatten und somit in gutem Kontrast zu den unbelichteten Bereichen standen, mit einer Entwicklerlösung aus 81 % Wasser, 16 % 2-Butoxyethanol und 3 % Triethanolamin in 20 Minuten ausgewaschen.

Es wurde ein blaues scharfkantiges positives Bild der Vorlage erhalten, das durch Abblasen mit Druckluft von Entwicklerlösungsmittel-Resten befreit wurde. Anschließend wurde mit der gleichen Lampe wie oben nochmals vollflächig, d. h. ohne bildmäßige Vorlage, für eine Dauer von 20 Minuten belichtet und die Resistschicht bei steigender Temperatur 30 Minuten bei 60 °C, 80 °C, 100 °C und 120 °C gehärtet. Die freiliegenden Bereiche des Aluminiums wurden in einem Ätzbad aus 1,5 l reiner Phosphorsäure, 150 ml Eisessig, 150 ml Salpetersäure und 200 ml entionisiertem Wasser bei 60 °C und einer Behandlungszeit von 1 Minute weggeätzt. Das von dem Resistmuster geschützte Aluminium wurde nicht angegriffen. Nach dem Spülen der Probe mit Wasser und Strippen des Resistmusters mit

Methylenchlorid wurden so akurate Aluminiumbahnen erhalten, die eine getreue Wiedergabe der Bildvorlage darstellten.

Beispiel 2

Es wurde wie in Beispiel 1 verfahren, jedoch wurde diesmal die lichtempfindliche Resistschicht vor dem Auflaminieren auf das Aluminium-bedampfte Glas von ihrer freien Oberfläche her 75 Sekunden lang mit der Höchstdruck-Quecksilber-Lampe vorbelichtet. Hierdurch konnte die Belichtungszeit bei der bildmäßigen Belichtung auf 6 Minuten reduziert, die Entwicklungszeit auf 5 Minuten und die Belichtungszeit für die vollflächige Nachbelichtung auf 15 Minuten verkürzt werden. Ansonsten wurde wie in Beispiel 1 verfahren. Man erhielt ein Resistmuster, welches ebenfalls eine ausgezeichnete Beständigkeit gegenüber dem Ätzbad für das Aluminium aufwies.

Beispiel 3

Es wurde wie in Beispiel 2 verfahren mit dem Unterschied, daß anstelle der Aluminium-bedampften Glasplatte ein palladiumbeschichtetes Substrat als permanenter Träger für die lichtempfindliche Resistschicht verwendet wurde. Die thermische Härtung der belichteten und entwickelten Resistschicht erfolgte in diesem Fall 30 Minuten bei 60 °C, 80 °C, 100 °C, 30 Minuten bei 120 °C, 30 Minuten bei 160 °C und 120 Minuten bei 200 °C. Das erhaltene Resistmuster war gegen ein Palladium-Ätzbad stabil und konnte nach der Ätzung mit heißem Dimethylformamid entfernt werden.

Beispiel 4

Eine entsprechend Beispiel 1 aus den Bestandteilen der lichtempfindlichen Schicht hergestellte Lösung wird in einer Laminarbox mittels des spin-coating-Verfahrens bei 5 000 Upm mittels einer Glasspritze auf eine oberflächlich oxidierte Silicium-Scheibe aufgebracht. Die lichtempfindliche Resistschicht wird bei 80 °C getrocknet und anschließend durch eine Chrom-Glasmaske bildmäßig belichtet, entwickelt und anschließend nochmals vollflächig nachbelichtet. Die Härtung der nachbelichteten Resistschicht erfolgt stufenweise entsprechend Beispiel 3. Die freigelegten Siliciumdioxid-Bereiche werden mit Flußsäure bis hinab zum nicht oxidierten Silicium weggeätzt und anschließend die Resistschicht mit heißem Dimethylformamid gestrippt.

Das freigelegte Silicium wird in bekannter Weise mit Boratomen p-dotiert. Nun werden die vorbeschriebene Arbeitsschritte wiederholt, d. h. die Silicium-Scheibe wird als ganzes wieder oxidiert, mit der lichtempfindlichen Resistschicht beschichtet, durch bildmäßige Belichtung, Entwicklung, Nachbelichtung und Härtung ein Resistmuster hergestellt, die freigelegten Siliciumdioxid-Bereiche bis zum nichtoxidierten Silicium geätzt, die Resistschicht gestrippt und anschließend das Silicium mit Phosphor n-dotiert. Mittels des gleichen photochemischen Prozesses werden Kontaktöffnungen geschaffen und danach die Scheibe mit Aluminium bedampft. Die Aluminiumschicht wird entsprechend Beispiel 2 so strukturiert, daß durch die resultierenden Aluminiumbahnen die p- und n-dotierten Zonen kontaktiert sind.

Beispiel 5

Es wurde wie in Beispiel 1 verfahren mit dem Unterschied, daß anstelle des Bisphenol-A-diglycidylethers diesmal 27 Teile eines Triisocyanates (hergestellt aus 3 Mol Hexamethylendiisocyanat und 1 Mol Wasser) eingesetzt werden. Die lichtempfindliche Resistschicht wurde nach Vorbelichtung wie in Beispiel 2 auf aluminiumbedampftes Glas auflaminiert. Die Zeit für die bildmäßige Belichtung betrug 15 Minuten, die Entwicklungszeit 6 Minuten. Nachbelichtung und Härtung erfolgten wie in Beispiel 1. Es wurde ein einwandfreies Resistmuster erhalten ; die freigelegten Bereiche des Aluminiums konnten in üblichen Bädern ohne Schwierigkeiten geätzt und galvanisiert werden.

Beispiel 6

Es wurde wie in Beispiel 3 verfahren mit dem Unterschied, daß anstelle des Bisphenol-A-diglycidylethers diesmal 27 Teile des Triisocyanats von Beispiel 5 eingesetzt wurden, dessen Biuretgruppen jedoch mit Methylethylketoxim verkappt waren. Die Zeit für die bildmäßige Belichtung betrug 4 min, für die Entwicklung 3 min und für die vollflächige Nachbelichtung 15 min. Die thermische Härtung erfolgte stufenweise 3 Stunden bei 160 °C und 2 Stunden bei 200 °C. Der Resist war gegen Ätzbäder beständig.

Beispiel 7

Es wurde wie in Beispiel 1 verfahren, mit dem Unterschied, daß die Hälfte (13,5 Teile) des Bisphenol-A-diglycidylethers durch die entsprechende Menge eines Triisocyanats (hergestellt aus 3 Mol Hexamethylendiisocyanat und 1 Mol Wasser) ersetzt wurde. Nach einer Vorbelichtung wie in Beispiel 2 wurde 3

Minuten bildmäßig belichtet, 2 Minuten entwickelt und 15 Minuten vollflächig nachbelichtet. Die Härtung erfolgte wie in Beispiel 3. Es wurde eine getreue Wiedergabe der Bildvorlage erhalten ; der Resist wies eine sehr gute Beständigkeit bei der Weiterverarbeitung auf.

Beispiel 8

Es wurde entsprechend wie in Beispiel 1 auf Polyesterfolien als temporären Trägern zwei 50 µm dicke lichtempfindliche Resistschichten hergestellt, wobei jedoch diesmal ein Methylmethacrylat-Copolymerisat verwendet wurde, welches 25 % o-Nitrobenzylacrylat einpolymerisiert enthielt. Die lichtempfindlichen Resistschichten wurden beidseitig auf eine gedruckte Schaltung auflaminiert und nach Abziehen der Polyesterfolie gleichzeitig durch photographische Bildvorlagen, mit einem Flachbelichter 4 Minuten belichtet. Die belichteten Schichtteile wurden mit einem Entwicklerlösungsmittel aus 81 % Wasser, 16 % 2-Butoxyethanol und 3 % Triethanolamin in 20 Minuten ausgewaschen. Nach Abblasen mit Druckluft wurden die scharfkantigen, den Vorlagen exakt entsprechenden Resistbilder mit dem gleichen Flachbelichter 4 Minuten vollflächig nachbelichtet und mit steigender Temperatur je eine Stunde bei 60 °C, 80 °C und 120 °C und 2 Stunden bei 150 °C gehärtet. Die so erhaltenen Lötstoppmasken besaßen die gewünschten elektrischen Eigenschaften, thermische Stabilität und sehr gute mechanische Festigkeit. Nach dem Bestücken wurde die mit den Lötstoppmasken versehene gedruckte Schaltung über eine Lötwelle geführt.

Beispiel 9

Es wurde wie in Beispiel 8 verfahren mit dem Unterschied, daß die lichtempfindlichen Resistschichten vor dem Auflaminieren auf die gedruckte Schaltung von der der gedruckten Schaltung zugekehrten Oberfläche her vollflächig 30 Sekunden vorbelichtet wurden. Dadurch konnten die Zeiten für die bildmäßige Belichtung auf 2 Minuten, für die Entwicklung auf 17 Minuten und für die vollflächige Nachbelichtung auf 2 Minuten verkürzt werden. Ansonsten wurde wie in Beispiel 8 beschrieben verfahren.

Beispiel 10

Eine Lösung aus 110 Teilen eines Acrylat-Copolymerisats (87 % Acrylsäure-1-(o-nitrophenyl)-ethylester und 13 % Acrylamid), 12 Teilen eines Bisphenol-A-diglycidylethers (Epikote[R] 828 der Fa. Shell) und 1,2 Teilen eines blauen Farbstoffes in 800 Teilen Essigester wurden nach der Filtration so auf eine elektrisch aufgerauhte, anodisch oxidierte Aluminiumplatte für den Offset-Druck (mittlere Rauhtiefe : 3,5 µm) aufgetragen, daß eine lichtempfindliche Resistschicht mit einem Trockengewicht von 1,5 $g/m^2$ resultierte. Nach dem Ablüften bei 60 °C wurde die lichtempfindliche Schicht durch eine photographische Vorlage mit einer dotierten Quecksilber-Hochdrucklampe (Abstand 80 cm) eine Minute bildmäßig belichtet. Hiernach waren auch die Filmkanten wegbelichtet und tonungsfrei. Die Entwicklung erfolgte in einem Sprühwascher mit einem Gemisch aus 82 Teilen Wasser, 15 Teilen 2-Butoxyethanol und 3 Teilen Triethanolamin. Nach Abspülen mit Wasser und Behandeln mit 1 % $H_3PO_4$ resultierte eine Offset-Druckplatte, deren Eigenschaften durch vollflächiges Nachbelichten (10 Minuten) und anschließendes thermisches Härten (je 30 Minuten bei 60 °C, 80 °C, 100 °C, 120 °C, 150 °C) verbessert wurden. Die zu erwartende Auflagenhöhe der Offset-Druckplatten vor und nach der Härtung wurden im Sandsprühtest ermittelt. Sie betrug für die nicht gehärtete Platte ca. 100 000, während sie für die nachbelichtete und gehärtete Platte bei über 400 000 lag.

**Patentansprüche**

1. Verfahren zur Herstellung von Reliefbildern oder Resistmustern, die ein positives Abbild einer bildmäßigen Vorlage darstellen, bei dem eine auf einem Träger aufgebrachte feste lichtempfindliche Resistschicht, die als lichtempfindliche Komponente eine Verbindung mit mindestens zwei aromatischen und/oder heteroaromatischen o-Nitrocarbinolestergruppierungen der allgemeinen Formel (I)

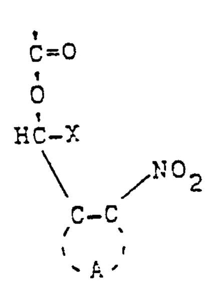

(I)

enthält, worin A den Rest eines aromatischen oder heteroaromatischen, gegebenenfalls substituierten Ringsystems mit 5 bis 14 Ringgliedern und X ein Wasserstoffatom, einen Alkylrest mit 1 bis 8 Kohlenstoffatomen oder einen gegebenenfalls substituierten Aryl- oder Aralkylrest bedeuten, mit aktinischem Licht bildmäßig belichtet wird und anschließend die belichteten Bereiche der Resistschicht mit einem wäßrigen Entwicklerlösungsmittel ausgewaschen werden, dadurch gekennzeichnet, daß die lichtempfindliche Resistschicht auch eine vernetzend wirkende Verbindung mit mindestens 2 reaktiven Gruppen enthält, die unter dem Einfluß von Wärme mit —COOH-Gruppen unter Bildung einer kovalenten chemischen Bindung zu reagieren vermögen, und daß die lichtempfindliche Resistschicht nach dem bildmäßigen Belichten und Entwickeln vollflächig mit aktinischem Licht nachbelichtet und anschließend thermisch vernetzt und gehärtet wird.

2. Verfahren nach Anspruch 1, dadurch gekennzeichnet, daß die lichtempfindliche Resistschicht eine Verbindung mit o-Nitrocarbinolestergruppierungen der allgemeinen Formel (I) enthält, in der das den o-Nitrocarbinolestergruppierungen der Formel (I) zugrundeliegende Carbinol o-Nitrobenzylalkohol, 2-Nitro-6-chlorbenzylalkohol, 2-Nitro-4-cyanbenzylalkohol, 2-Nitro-4,5-dimethoxybenzylalkohol, α-Methyl-o-nitrobenzylalkohol, α-Phenyl-o-nitrobenzylalkohol oder α-(o-Nitrophenyl)-o-nitrobenzylalkohol ist.

3. Verfahren nach Ansprüchen 1 oder 2, dadurch gekennzeichnet, daß die lichtempfindliche Resistschicht als Verbindung mit den o-Nitrocarbinolestergruppierungen der Formel (I) einen Di- und/oder Polyester einer niedermolekularen Di- und/oder Polycarbonsäure sowie zusätzlich ein mit diesen Estern verträgliches polymeres Bindemittel enthält.

4. Verfahren nach Ansprüchen 1 oder 2, dadurch gekennzeichnet, daß die lichtempfindliche Resistschicht ein Polymeres mit einem Molekulargewicht größer 500 enthält, welches zumindest 5 Gew.%, bezogen auf das Molekulargewicht des Polymeren, aromatische und/oder heteroaromatische o-Nitrocarbinolestergruppierungen der allgemeinen Formel (I) im Molekül gebunden enthält.

5. Verfahren nach Anspruch 4, dadurch gekennzeichnet, daß die lichtempfindliche Resistschicht ein o-Nitrocarbinolestergruppierungen der Formel (I) tragendes Polymeres enthält, welches sich von einem Homo- oder Copolymerisat der Acrylsäure, Methacrylsäure, Maleinsäure, Fumarsäure und/oder Crotonsäure ableitet.

6. Verfahren nach einem der Ansprüche 1 bis 5, dadurch gekennzeichnet, daß die lichtempfindliche Resistschicht eine Verbindung, insbesondere ein Polymeres, enthält, welche neben den o-Nitrocarbinolestergruppierungen der Formel (I) gleichzeitig die vernetzend wirkenden, reaktiven Gruppen im Molekül eingebaut enthält.

7. Verfahren nach Anspruch 6, dadurch gekennzeichnet, daß die o-Nitrocarbinolestergruppierungen der Formel (I) enthaltende Verbindung zusätzlich Amin-, Imin-, Amid-, Epoxid-, Hydroxy-, Isocyanat- und/oder verkappte Isocyanat-Gruppen eingebaut enthält.

8. Verfahren nach einem der Ansprüche 1 bis 5, dadurch gekennzeichnet, daß die lichtempfindliche Resistschicht neben der Verbindung mit den o-Nitrocarbinolestergruppierungen der Formel (I) zusätzlich eine oder mehrere vernetzend wirkende Verbindungen mit mindestens 2 reaktiven Gruppen der genannten Art enthält.

9. Verfahren nach Anspruch 8, dadurch gekennzeichnet, daß die lichtempfindliche Resistschicht als vernetzend wirkende Verbindung ein Epoxid mit zwei oder mehr Epoxidgruppen oder ein Isocyanat mit zwei oder mehr gegebenenfalls verkappten Isocyanatgruppen enthält.

10. Verfahren nach Anspruch 8, dadurch gekennzeichnet, daß die vernetzend wirkende Verbindung ein α,ω-Diisocyanatopolycarbodiimid ist.

11. Verfahren nach Anspruch 8, dadurch gekennzeichnet, daß die vernetzend wirkende Verbindung zwei oder mehr Hydroxy- und/oder Amino-Gruppen enthält.

12. Verfahren nach Ansprüchen 1 bis 11, dadurch gekennzeichnet, daß die lichtempfindliche Resistschicht als weitere Zusatzstoffe Weichmacher, Verlaufsmittels, Katalysatoren für die thermische Härtung, Sensibilisatoren, Farbstoffe, Pigmente und/oder photochrome Substanzen enthält.

13. Verfahren nach Ansprüchen 1 bis 12, dadurch gekennzeichnet, daß die thermische Vernetzung und Härtung der nachbelichteten Resistschicht bei Temperaturen im Bereich von 50 bis 250 °C vorgenommen wird.

14. Verfahren nach Ansprüchen 1 bis 13, dadurch gekennzeichnet, daß die Dicke der lichtempfindlichen Schicht im Bereich von 0,1 bis 2 000 μm liegt.

15. Verfahren nach Ansprüchen 1 bis 14, dadurch gekennzeichnet, daß die trockene, feste, lichtempfindliche Resistschicht unter Anwendung von Druck und/oder Wärme auf den Träger auflaminiert worden ist.

16. Verfahren nach Anspruch 15, dadurch gekennzeichnet, daß die lichtempfindliche Resistschicht vor dem Aufbringen auf den Träger auf der dem Träger zugewandten Seite kurzzeitig mit aktinischem Licht vollflächig vorbelichtet worden ist.

17. Verfahren nach Ansprüchen 1 bis 16, dadurch gekennzeichnet, daß die lichtempfindliche Resistschicht vor der vollflächigen Nachbelichtung und thermischen Härtung mehrfach wechselweise bildmäßig belichtet und mit dem Entwicklerlösungsmittel ausgewaschen wird, wobei nach dem Auswaschen vor jedem weiteren bildmäßigen Belichten die freigelegten Bereiche des Trägers modifiziert werden.

18. Verfahren nach einem der Ansprüche 1 bis 17, dadurch gekennzeichnet, daß die lichtempfindliche Resistschicht auf einem perforierten Träger aufgebracht ist und durch die Perforationen des Trägers unter Ausnutzung des Trägers als Photomaske bildmäßig belichtet wird.

19. Verfahren nach Anspruch 18, dadurch gekennzeichnet, daß vor der bildmäßigen Belichtung auf die dem Träger abgewandte Oberfläche der lichtempfindlichen Resistschicht eine lichtstreuende oder spiegelnde Schicht, Folie oder Platte aufgebracht wird.

20. Anwendung des Verfahrens nach einem der Ansprüche 1 bis 19 in der Halbleitertechnik, zur Herstellung von Leiterbahnen, integrierten oder gedruckten Schaltungen oder von Lötstoppmasken.

21. Anwendung des Verfahrens nach einem der Ansprüche 1 bis 16 zur Herstellung von Offset-Druckplatten.

**Claims**

1. A process for the production of a relief image or a resist image which constitutes a positive image of an imagebearing transparency, in which a solid photosensitive resist layer which is applied to a base and contains, as the photosensitive component, a compound possessing two or more aromatic and/or heteroaromatic o-nitrocarbinol ester groups of the general formula (I)

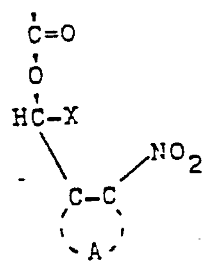

(I)

where A is a radical of an unsubstituted or substituted 5-membered to 14-membered aromatic or heteroaromatic ring system, and X is hydrogen, alkyl of 1 to 8 carbon atoms or an unsubstituted or substituted aryl or aralkyl radical, is exposed imagewise to actinic light, and then the exposed areas of the resist layer are washed out with an aqueous developer, characterized in that the photosensitive resist layer also contains a compound which effects crosslinking and possesses 2 or more reactive groups which are capable of reacting with —COOH groups under the action of heat to from a covalent chemical bond, and that the photosensitive resist layer, after imagewise exposure and development, is post-exposed uniformly to actinic light and then thermally crosslinked and hardened.

2. A process as claimed in claim 1, characterized in that the photosensitive resist layer contains a compound possessing o-nitrocarbinol ester groups of the general formula (I), in which the carbinol on which the o-nitrocarbinol ester groups of the formula (I) are based is o-nitrobenzyl alcohol, 2-nitro-6-chlorobenzyl alcohol, 2-nitro-4-cyanobenzyl alcohol, 2-nitro-4,5-dimethoxybenzyl alcohol, α-methyl-o-nitrobenzyl alcohol, α-phenyl-o-nitrobenzyl alcohol or α-(o-nitrophenyl)-o-nitrobenzyl alcohol.

3. A process as claimed in claim 1 or 2, characterized in that the photosensitive resist layer contains, as the compound possessing the o-nitrocarbinol ester groups of the formula (I), a di- and/or polyester of a low molecular weight di- and/or polycarboxylic acid and in addition a polymeric binder which is compatible with these esters.

4. A process as claimed in claim 1 or 2, characterized in that the photosensitive resist layer contains a polymer which has a molecular weight of above 500 and contains not less than 5 % by weight, based on the molecular weight of the polymer, of aromatic and/or heteroaromatic o-nitrocarbinol ester groups of the formula (I) bonded in the molecule.

5. A process as claimed in claim 4, characterized in that the photosensitive resist layer contains a polymer which possesses o-nitrocarbinol ester groups of the formula (I) and is derived from a homopolymer or copolymer of acrylic acid, methacrylic acid, maleic acid, fumaric acid and/or crotonic acid.

6. A process as claimed in any of claims 1 to 5, characterized in that the photosensitive resist layer contains a compound, in particular a polymer, which, in addition to the o-nitrocarbinol ester groups of the formula (I), also contains the crosslinking reactive groups incorporated in the molecule.

7. A process as claimed in claim 6, characterized in that the compound possessing o-nitrocarbinol ester groups of the formula (I) additionally contains amine, imine, amide, epoxide, hydroxyl, isocyanate and/or blocked isocyanate groups.

8. A process as claimed in any of claims 1 to 5, characterized in that the photosensitive resist layer contains, in addition to the compound possessing the o-nitrocarbinol ester groups of the formula (I), one or more crosslinking compounds possessing 2 or more reactive groups of the said type.

9. A process as claimed in claim 8, characterized in that the photosensitive resist layer contains, as crosslinking compound, an epoxide possessing two or more epoxide groups or an isocyanate possessing

two or more free or blocked isocyanate groups.

10. A process as claimed in claim 8, characterized in that the crosslinking compound is an $\alpha,\omega$-diisocyanatopolycarbodiimide.

11. A process as claimed in claim 8, characterized in that the crosslinking compound contains two or more hydroxyl and/or amino groups.

12. A process as claimed in claims 1 to 11, characterized in that the photosensitive resist layer contains, as further additives, plasticizers, flow improvers, catalysts for the thermal hardening, sensitizers, dyes, pigments and /or photochromic substances.

13. A process as claimed in claims 1 to 12, characterized in that the thermal crosslinking and hardening of the post-exposed resist layer is carried out at from 50 to 250 °C.

14. A process as claimed in claims 1 to 13, characterized in that the photosensitive layer is from 0,1 to 2,000 $\mu$m thick.

15. A process as claimed in claims 1 to 14, characterized in that the dry, solid photosensitive resist layer is laminated onto the base using pressure and/or heat.

16. A process as claimed in claim 15, characterized in that the photosensitive resist layer, before being applied to the base, is pre-exposed uniformly for a short time to actinic light, on that side which faces the base.

17. A process as claimed in claims 1 to 16, characterized in that the photosensitive resist layer, before being uniformly post-exposed and thermally hardened, is alternately exposed imagewise and washed out with the developer several times, the bared areas of the base being modified after the washing-out operation but before each subsequent imagewise exposure.

18. A process as claimed in any of claims 1 to 17, characterized in that the photosensitive resist layer is applied to a perforated base, and, using the latter as a photomask, is exposed imagewise through the perforations therein.

19. A process as claimed in claim 18, wherein, before imagewise exposure, a light-scattering or reflecting layer, film or sheet is applied to that surface of the photosensitive resist layer which faces away from the base.

20. The use of a process as claimed in any of claims 1 to 19 in semiconductor technology for the production of conductors, integrated or printed circuits, or solder masks.

21. The use of a process as claimed in any of claims 1 to 16 for the production of offset printing plates.

**Revendications**

1. Procédé de préparation d'images en relief ou de dessins-réserves (resist), qui représentent une image positive d'un modèle selon l'image, procédé selon lequel on expose, conformément à l'image, à une lumière actinique, une couche-réserve (resist) solide, sensible à la lumière, appliquée sur un support, couche qui contient, comme composants sensibles à la lumière, un composé ayant au moins deux groupements ester de o-nitrocarbinol aromatiques et/ou hétéro-aromatiques, de formule générale (I)

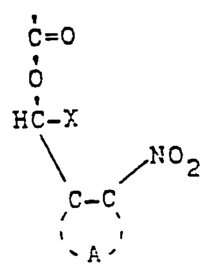

(I)

où A représente le reste d'un système cyclique aromatique ou hétéro-aromatique, éventuellement substitué, ayant 5 à 14 termes cycliques, et X un atome d'hydrogène, un reste alkyle de 1 à 8 atomes de carbone ou un reste aryle ou aralkyle éventuellement substitué, et ensuite on élimine, avec un solvant révélateur aqueux, les zones exposées de la couche-réserve, caractérisé par le fait que la couche-réserve sensible à la lumière contient aussi un composé à effet réticulant ayant au moins deux groupes réactifs qui, sous l'influence de la chaleur, peuvent réagir avec des groupes —COOH— en formant une liaison chimique covalente, et après l'exposition selon l'image et le développement, on réexpose à la lumière actinique, sur toute sa surface, la couche-réserve sensible à la lumière, puis on réticule et durcit thermiquement.

2. Procédé selon la revendication 1, caractérisé par le fait que la couche-réserve, sensible à la lumière, contient un composé possédant des groupements ester d'o-nitrocarbinol de formule générale (I), dans lequel le carbinol servant de base aux groupements ester d'o-nitrocarbinol de formule I est l'alcool o-nitrobenzylique, 2-nitro-6-chloro-benzylique, 2-nitro-4-cyanobenzylique, 2-nitro-4,5-diméthoxybenzylique, $\alpha$-méthyl-o-nitrobenzylique, $\alpha$-phényl-o-nitrobenzylique ou $\alpha$-(o-nitrophényl)-o-nitrobenzylique.

3. Procédé selon les revendications 1 et 2, caractérisé par le fait que la couche-réserve, sensible à la lumière, contient, comme composé à groupement ester d'o-nitrocarbinol de formule (I), un di- et/ou polyester, un di- et/ou polyacide carboxylique à bas poids moléculaire ainsi qu'un liant polymère compatible avec cet ester.

4. Procédé selon les revendications 1 et 2, caractérisé par le fait que la couche-réserve, sensible à la lumière, contient un polymère d'un poids moléculaire supérieur à 500, qui contient, liés à la molécule, au moins 5 % en poids, rapportés au poids moléculaire du polymère, de groupements ester d'o-nitrocarbinol aromatiques et/ou hétéro-aromatiques, de formule (I).

5. Procédé selon la revendication 4, caractérisé par le fait que la couche-réserve, sensible à la lumière, contient un polymère, portant des groupements ester d'o-nitrocarbinol de formule (I), qui dérive d'un homo- ou copolymérisat de l'acide acrylique, méthacrylique, maléique, fumarique et/ou crotonique.

6. Procédé selon l'une des revendications 1 à 5, caractérisé par le fait que la couche-réserve, sensible à la lumière, contient un composé, en particulier un polymère, qui, outre les groupements ester de o-nitrocarbinol, de formule (I), contient, en même temps, incorporés dans la molécule, les groupes réactifs vis-à-vis des groupes —COOH, agissant comme réticulants.

7. Procédé selon la revendication 6, caractérisé par le fait que le composé, contenant les groupements ester de o-nitrocarbinol de formule (I), contient, en outre, incorporés, des groupes amine, imine, amide, époxyde, hydroxy, isocyanate et/ou isocyanate masqué.

8. Procédé selon l'une des revendications 1 à 5, caractérisé par le fait que la couche-réserve, sensible à la lumière, outre le composé à groupements ester de o-nitrocarbinol de formule (I), contient en plus un ou plusieurs composés à effet réticulant ayant au moins deux groupes réactifs du type indiqué.

9. Procédé selon la revendication 8, caractérisé par le fait que la couche-réserve, sensible à la lumière, contient comme composé à effet réticulant, un époxyde à deux ou plus de deux groupes époxyde ou un isocyanate à deux ou plus de deux groupes isocyanate éventuellement masqués.

10. Procédé selon la revendication 8, caractérisé par le fait que le composé à effet réticulant est un $\alpha,\omega$-diisocyanatopolycarbodimide.

11. Procédé selon la revendication 8, caractérisé par le fait que le composé à effet réticulant contient deux, ou plus de deux, groupes hydroxy et/ou amino.

12. Procédé selon les revendications 1 à 11, caractérisé par le fait que la couche-réserve, sensible à la lumière, contient, comme autres additifs, des plastifiants, agents d'étalement, catalyseurs pour le durcissement thermique, sensibilisateurs, colorants, pigments et/ou substances photochromes.

13. Procédé selon les revendications 1 à 12, caractérisé par le fait que le durcissement-réticulation thermique de la couche-réserve, exposée selon l'image, est effectué à des températures de la zone allant de 50 à 250 °C.

14. Procédé selon les revendications 1 à 13, caractérisé par le fait que l'épaisseur de la couche sensible à la lumière est de 0,1 à 2 000 µm.

15. Procédé selon les revendications 1 à 14, caractérisé par le fait que la couche-réserve, solide, sensible à la lumière, a été appliquée, par laminage, sur le support en utilisant la pression et/ou de la chaleur.

16. Procédé selon la revendication 15, caractérisé par le fait que la couche-réserve, sensible à la lumière, avant d'être appliquée par laminage sur le support, a été soumise, pendant un court moment, sur toute la surface de son côté tourné vers le support, à une pré-exposition à la lumière actinique.

17. Procédé selon les revendications 1 à 16, caractérisé par le fait que la couche-réserve, sensible à la lumière, avant la post-exposition sur toute la surface et le durcissement thermique, est alternativement exposée, selon l'image , et lavée avec le solvant révélateur, les zones du support laissées libres étant modifiées après le lavage avant toute autre exposition selon l'image.

18. Procédé selon l'une des revendications 1 à 17, caractérisé par le fait que la couche-réserve, sensible à la lumière, est appliquée sur un support perforé et est exposée, selon une image, à travers les perforations du support, en utilisant le support comme masque photo.

19. Procédé selon la revendication 18, caractérisé par le fait qu'avant l'exposition, selon l'image, on applique sur la surface de la couche-réserve, sensible à la lumière, écartée du support, une couche, feuille ou plaque, diffusant ou réfléchissant la lumière.

20. Utilisation du procédé selon les revendications 1 à 19, dans la technique des semi-conducteurs, pour la fabrication de pistes conductrices, de circuits intégrés ou imprimés ou de masques d'arrêt à soudure.

21. Utilisation du procédé selon les revendications 1 à 16, pour la fabrication de plaques offset.